**Europäisches Patentamt**

**European Patent Office**

**Office européen des brevets**

(19)

(11) Veröffentlichungsnummer: **0 122 446**

**A1**

(12) # EUROPÄISCHE PATENTANMELDUNG

(21) Anmeldenummer: 84102628.9

(22) Anmeldetag: **10.03.84**

(51) Int. Cl.³: **C 30 B 23/02**
**C 23 C 13/08**

(30) Priorität: **19.03.83 DE 3310044**

(43) Veröffentlichungstag der Anmeldung:
**24.10.84 Patentblatt 84/43**

(84) Benannte Vertragsstaaten:
**DE FR GB**

(71) Anmelder: **Licentia Patent-Verwaltungs-GmbH**
**Theodor-Stern-Kai 1**
**D-6000 Frankfurt/Main 70(DE)**

(72) Erfinder: **Herzog, Hans-Joest, Dipl.-Phys.**
**Staufenbergstrasse 18**
**D-7910 Neu-Ulm/Pfuhl(DE)**

(72) Erfinder: **Kibbel, Horst**
**Buchenstrasse 23**
**D-7904 Erbach(DE)**

(74) Vertreter: **Amersbach, Werner, Dipl.-Ing. et al,**
**Licentia Patent-Verwaltungs-GmbH Theodor-Stern-Kai 1**
**D-6000 Frankfurt 70(DE)**

(54) **Verfahren und Anordnung zur Beschichtung eines Substrates.**

(57) Die Erfindung betrifft insbesondere ein Molekularstrahl-verfahren (MBE-Verfahren) zur Beschichtung von großflächigen Substraten, z.B. von 3''-Si-Substraten. Bei dem erforderlichen Beschichtungsvorgang wird eine Schankung der Schichtdicke vermieden durch eine Taumelbewegung des Substrates.

EP 0 122 446 A1

Licentia Patent-Verwaltungs-GmbH    PTL-UL/Ja/rß
Theodor-Stern-Kai 1                  UL 82/189
D-6000 Frankfurt 70                  Aktz.: P 33 10 044.6

— 1 —

Beschreibung

**Verfahren und Anordnung zur
Beschichtung eines Substrates**

Die Erfindung betrifft ein Verfahren und eine Anordnung zur Beschichtung eines Substrates nach den Oberbegriffen der Patentansprüche 1 und 3.

Die Erfindung betrifft insbesondere die Abscheidung von z.B. Silizium auf großflächigen Substrate für die Herstellung von Halbleiter-Bauelementen. Bei einer wirtschaftlichen Herstellung dieser Bauelemente ist es zweckmäßig; von einem möglichst großflächigen Substrat auszugeben, z.B. einer kreisförmigen Scheibe aus Silizium mit einem Durchmesser von 3" (= 75mm). Dieses

. . .

0122446

UL 82/189

Substrat wird im Vakuum beschichtet, z.B. nach einem Molekularstrahl-Epitaxieverfahren (MBE-Verfahren). Für eine hohe Ausbeute an Halbleiter-Bauelementen ist es wesentlich, daß die derart aufgebrachte(n) Schicht(en) auf der zu beschichtenden Fläche des Substrates eine möglichst gleichmäßige Schichtdicke besitzen. Bei einer derartigen Beschichtung muß berücksichtigt werden, daß der von einer Molekularstrahlquelle ausgesandte Molekularstrahl eine richtungsabhängige Intensität besitzt, z.B. gemäß einer Verteilung ($n \approx 1...3$). Es ist bekannt, diese Richtungs- abhängigkeit dadurch auszugleichen, daß das zu beschichtende Substrat um eine Achse gedreht wird, die ungefähr senkrecht steht auf der zu beschichtenden Fläche. Bei dem erwähnten MBE-Verfahren ist es notwendig, das zu beschichtende Substrat während des Beschichtungsvorganges gleichmäßig auf einer bestimmten Temperatur, z.B. 500°C, zu halten. Eine solche Temperaturverteilung ist erreichbar durch einen elektrisch direkt beheizten Substrathalter, auf dem das Substrat mit einem möglichst guten Wärmekontakt angebracht ist. Wird ein solcher Substrathalter innerhalb einer Vakuumkammer gedreht, so sind zur Stromzuführung der Heizung innerhalb der Vakuumkammer Schleifkontakte nötig, die störanfällig sind (Verschweißen).

Aufgabe der Erfindung ist es daher, ein gattungsgemäßes Verfahren und eine gattungsgemäße Anordnung anzugeben, die bei großflächigen Substraten eine gleichmäßige Beschichtung ermöglichen, bei der insbesondere eine Substratbeheizung benötigt wird.

...

Diese Aufgabe wird erfindungsgemäß gelöst durch die in den kennzeichnenden Teilen der Patentansprüche 1 und 3 angegebenen Merkmale. Ausgestaltungen und Weiterbildungen der Erfindung sind den Unteransprüche entnehmbar.

Die Erfindung wird im folgenden näher erläutert anhand eines Ausführungsbeispieles unter Bezugnahme auf eine schematische Zeichnung.

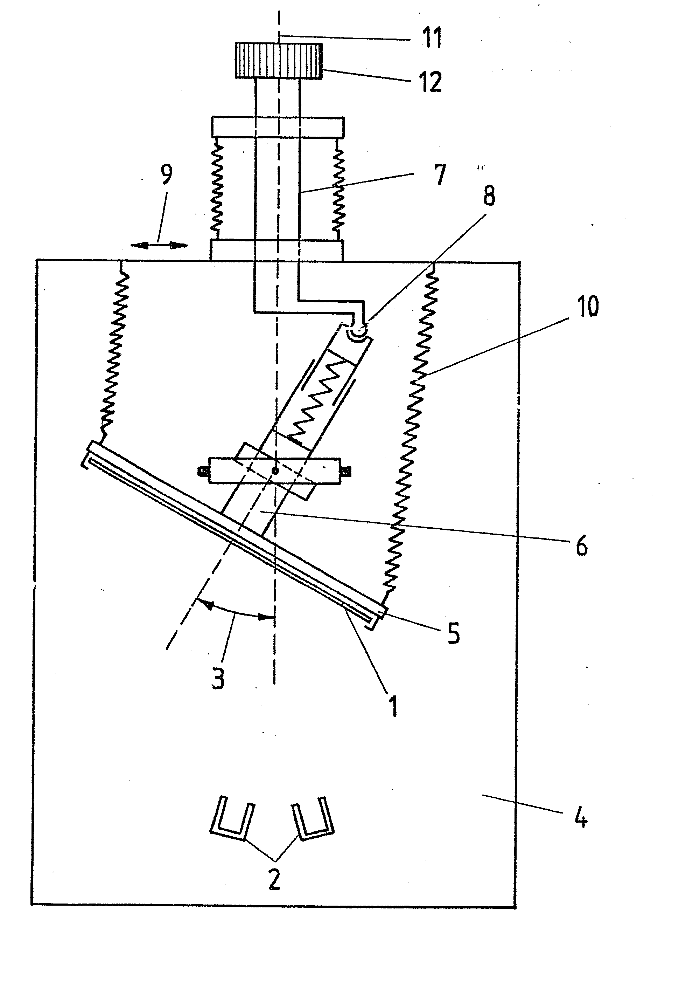

Die Figur zeigt eine Vakuumkammer 4, z.B. eine Ultrahochvakuumkammer für ein MBE-Verfahren, in der ein elektrisch direkt beheizbarer Substrathalter 5 vorhanden ist, an dem das zu beschichtende Substrat 1 befestigt wird, z.B. ein 3"-Si-Substrat für die Halbleiterfertigung.

Das Substrat 1 wird beschichtet durch Molekularstrahlen, die von mindestens einer Molekularstrahlquelle 2 ausgesandt werden. Die Intensitätsverteilung der ausgesandten Molekularstrahlen entspricht im allgemeinen einer $\cos^n$-Verteilung, die bei einem unbewegten Substrat 1 zu einer ungleichmäßigen Schichtdicke führt. Dieser Nachteil wird erfindungsgemäß dadurch vermieden, daß das auf dem Substrathalter 5 befestigte Substrat 1 während des Beschichtungsvorganges in eine Taumelbewegung versetzt wird, die durch einen einstellbaren Taumelwinkel 3 bestimmt wird.

Diese Taumelbewegung wird dadurch möglich, daß der Substrathalter 5 an einer kardanisch gelagerten Aufhängung 6 befestigt ist, deren eine Seite auf einer kreisförmigen Bahn um eine Symmetrieachse 11 bewegt wird. Dieses wird

...

erreicht durch eine an der Vakuumkammer 4 angebrachten
Dreh- oder Drehschiebedurchführung 7, an deren einem Ende
sich eine kurbelförmige Anlenkvorrichtung 8 befindet,
durch welche die Aufhängung 6 bewegt wird. Die dargestellte
Drehschiebedurchführung 7 wird während der Beschichtung um
die Symmetrieachse 11 gedreht mit Hilfe eines außerhalb
der Vakuumkammer angebrachten Handrades 12 und/oder eines
daran angekoppelten Motors. Eine Verstellung des Taumelwinkels 3 ist beispielsweise dadurch möglich, daß die
Drehschiebedurchführung 7 in axialer Richtung bewegt wird.
Über die Anlenkvorrichtung 8 wird dadurch eine Längenänderung bewirkt, so daß sich deren Hebelverhältnis ändert.

Zum Wechseln des Substrates 1 ist es zweckmäßig, den
Substrathalter 5 in eine horizontale Lage zu bringen.
Dieses ist möglich durch eine Verschiebung der Drehschiebedurchführung 7 in einer radialen Richtung 9. Da der beheizbare Substrathalter 5 lediglich eine Taumelbewegung ausführt, sind für die elektrischen (Heizungs-)Zuleitungen
keine Schleifringe erforderlich, sondern lediglich Zuleitungen, deren Länge veränderlich ist, z.B. schraubenförmig
aufgewickelte Zuleitungen.

Die Erfindung ist nicht auf das beschriebene Ausführungsbeispiel beschränkt, sondern sinngemäß auf weitere Anordnungen anwendbar. Beispielsweise ist das Verfahren nicht
auf kristalline Abscheidung beschränkt, sondern ist auch
bei Aufdampfverfahren in Vakuumanlagen anwendbar, bei
denen Materialien aus Quellen verdampft werden und auf
großflächigen Substraten mit hoher Schichtdickengleich-

...

mäßigkeit abgeschieden werden sollen. Eine Änderung des Taumelwinkels ist alternativ möglich durch eine Längenänderung des in der Figur horizontal dargestellten Teiles der Anlenkvorrichtung.

0122446

Licentia Patent-Verwaltungs-GmbH
Theodor-Stern-Kai 1

D-6000 Frankfurt 70

PTL-UL/Ja/rß
UL 82/189

Aktz.: P 33 10 044.6

Patentansprüche

1. Verfahren zur Beschichtung eines Substrates, das in einer Vakuumkammer angeordnet wird und das durch mindestens eine Molekularstrahlquelle beschichtet wird, dadurch gekennzeichnet, daß bei mindestens einem Beschichtungsvorgang das Substrat (1) und die Molekularstrahlquelle (2) relativ zueinander eine Taumelbewegung ausführen.

2. Verfahren nach Anspruch 1, dadurch gekennzeichnet, daß ein die Taumelbewegung bestimmender Taumelwinkel (3) eingestellt wird, dessen Größe zumindest in Abhängigkeit von der Strahlcharakteristik der Molekularstrahlquelle (2) und/oder den Eigenschaften der auf dem Substrat (1) abzuscheidenden Schicht bestimmt wird.

3. Anordnung zur Beschichtung eines Substrates, das in

...

0122446

einer Vakuumkammer angeordnet ist und das durch mindestens eine Molekularstrahlquelle beschichtet wird, gekennzeichnet durch folgende Merkmale:

a) innerhalb der Vakuumkammer (4) ist mindestens ein Substrathalter (5) vorhanden, auf dessen der Molekularstrahlquelle (2) zugewandten Seite mindestens ein Substrat (1) anbringbar ist.

b) der Substrathalter (5) ist mit seiner der Molekularstrahlquelle (2) abgewandten Seite an einer kardanisch gelagerten Aufhängung (6) befestigt

c) in einer Wandung der Vakuumkammer (4) ist eine vakuumdichte Dreh- oder Drehschiebedurchführung (7) vorhanden, an deren innerhalb der Vakuumkammer (4) befindlichen Ende eine Anlenkvorrichtung (8) vorhanden ist, durch welche der Taumelwinkel (3) einstellbar ist.

4. Anordnung nach Anspruch 3, dadurch gekennzeichnet, daß der Taumelwinkel (3) einstellbar ist durch ein axiale Verschiebung der Drehschiebedurchführung (7) und eine dadurch bewirkte Längenänderung der Aufhängung (6).

5. Anordnung nach Anspruch 3 oder Anspruch 4, dadurch gekennzeichnet, daß die Dreh- oder Drehschiebedurchführung (7) in mindestens einer radialen Richtung (9) verschiebbar ist

6. Anordnung nach einem der Ansprüche 3 bis 5, dadurch

. . .

gekennzeichnet, daß an dem Substrathalter (5) eine elektrische Heizung zur Beheizung des Substrates (1) vorhanden ist und daß die zur Heizung führenden elektrischen Zuleitungen (10) unter Vermeidung beweglicher Kontakte aus der Vakuumkammer (4) herausgeführt sind.

# Europäisches Patentamt

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | IBM TECHNICAL DISCLOSURE BULLETIN, Band 15, Nr. 3, August 1972, Seiten 990-991, New York, USA; A.R. HARDER et al.: "Substrate heater-manipulator for ultraclean evaporation" * Seiten 990-991; Figur * ----- | 1-3,5, 6 | C 30 B 23/02 C 23 C 13/08 |

RECHERCHIERTE SACHGEBIETE (Int. Cl. 3)

C 30 B 23/02
C 23 C 13/08

Der vorliegende Recherchenbericht wurde für alle Patentansprüche erstellt.

| Recherchenort | Abschlußdatum der Recherche | Prüfer |
|---|---|---|
| DEN HAAG | 27-06-1984 | BRACKE P.P.J.L. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82